# NEUE EUROPÄISCHE PATENTSCHRIFT

(11) **EP 1 133 796 B2**
(45) Veröffentlichungstag und Bekanntmachung des Hinweises auf die Entscheidung über den Einspruch: **28.04.2010**
(45) Hinweis auf die Patenterteilung: 12.10.2005
(21) Anmeldenummer: 99960780.7
(22) Anmeldetag: 12.10.1999
(51) Int. Cl.: H01L 23/498, G06K 19/077

(54) **VERFAHREN ZUR HERSTELLUNG EINES FLAECHIG AUSGEBILDETEN TRAEGERS FUER HALBLEITER- CHIPS**
A METHOD FOR PRODUCING A TWO-DIMENSIONAL SUPPORT FOR SEMICONDUCTOR CHIPS
PROCEDE DE FABRICATION D'UN SUPPORT PLAN POUR MICROPLAQUETTE SEMI-CONDUCTRICE

(30) Priorität: 13.10.1998 DE 19847088
(43) Veröffentlichungstag der Anmeldung: 19.09.2001
(73) Patentinhaber: KSW Microtec AG, 01099 Dresden (DE)
(72) Erfinder: SEIDOWSKI, Thomas, D-01157 Dresden (DE); KRIEBEL, Frank, D-01896 Lichtenberg (DE)
(74) Vertreter: Adler, Peter
(86) Internationale Anmeldenummer: PCT/DE1999/003322
(87) Internationale Veröffentlichungsnummer: WO 2000/022673

(56) Entgegenhaltungen:
- EP-A- 0 682 369
- EP-A- 0 824 301
- EP-A- 0 855 675
- DE-A- 19 642 378
- FR-A- 2 756 955

## Beschreibung

Die Erfindung betrifft ein Verfahren zur Herstellung eines flächig ausgebildeten Trägers der aus einem flexiblen, elektrisch isolierenden Material besteht und auf dem mindestens ein Halbleiter-Chip mit einer Leiterbahnstruktur, nachfolgend mit Leitbahnstrukturen bezeichnet, insbesondere zur kontaktlosen Datenübertragung aufgebracht ist.

Von W. Rankl/W. Effing sind im "Handbuch der Chipkarten", Hanser-Verlag, 2. Auflage bekannte Möglichkeiten für den Aufbau und die Herstellung von Chipkarten beschrieben worden. Dabei wurde im wesentlichen eine Unterscheidung in kontaktbehaftete und kontaktlose Karten getroffen. Insbesondere sind auf Seite 50 beispielhaft mögliche Anwendungen für die sog. "Remoute-Coupling-Karten" als Zugangskontrolle, für die Fahrzeugerkennung, als elektronischer Fahrschein, Skipaß, Flugticket, elektronische Geldbörse und für die Gepäckerkennung genannt.

Die bekannten Chipkarten, insbesondere die für die kontaktlose Datenübertragung geeigneten, verwenden üblicherweise ein auf einem Träger aufgebrachtes Halbleiter-Chip (Mikroprozessor, Speicherschaltkreis) in Verbindung mit sog. Koppelelementen, die für eine kontaktlose Daten- und gegebenenfalls Energieübertragung auf induktivem bzw. kapazitivem Wege geeignet sind. Solche Koppelelemente sind demzufolge in der Regel Spulen oder Kondensatoren.

Bisher ist es üblich, diese Koppelelemente und die elektrisch leitenden Verbindungen zum Halbleiter-Chip mittels aus der Leitplattenherstellung bekannter Verfahren herzustellen. Dabei wird auf einem metallisierten Kunststoffträger, in der Regel fotolithographisch die gewünschte Struktur erzeugt und im Anschluß daran, die Metallschicht in den ungeschützten Bereichen naßchemisch abgeätzt, so daß auf dem flexiblen Träger die gewünschte elektrische leitende Leitbahnstruktur, inclusive der Koppelelemente in Form einer Spule ausgebildet sind und im Anschluß daran, der jeweilige Halbleiter-Chip mit der Leitbahnstruktur kontaktiert und auf den Träger aufgebracht wird, wobei hierfür die bekannte Flip-Chip-Technik angewendet werden kann.

Es hat sich nun gezeigt, daß insbesondere die Ausbildung der Leitbahnstruktur auf dem Träger durch naßchemisches Ätzen problembehaftet ist, wobei insbesondere der anlagentechnische, der Zeit- und der Entsorgungsaufwand für die Ätzbadflüssigkeit nachteilig sind. Außerdem sind an das verwendete flexible Trägermaterial bestimmte Anforderungen zu stellen und diese bestehen in der Regel, da ein gewisses Maß an Flexibilität gefordert ist, aus einem Kunststoff. Aus Kostengründen werden normalerweise PVC-Folien verwendet, die relativ gut verarbeitbar, kostengünstig erhältlich und im Nachgang einfach und mit relativ guter Qualität bedruckbar sind.

Ein so vorbereitetes Vorprodukt, wird dann im Nachgang, z.B. durch Auflamminieren zu einer Chipkarte weiter verarbeitet.

Wegen der relativ vielen und unterschiedlichen betriebenen Verfahrensschritte, sind die so erhältlichen Endprodukte noch relativ teuer und können demzufolge aus Kostengründen für viele Applikationen noch nicht eingesetzt werden.

In DE 43 32 282 A1 ist ein Verfahren zur Herstellung von Leitbahnen auf Substraten mittels Siebdruck beschrieben, bei dem auf das Ätzen verzichtet werden kann. Dabei wird mittels Siebdruck eine Druckpaste, die einen leitenden Werkstoff enthält, direkt auf das Substrat aufgebracht und dieses so bedruckte Substrat, in der Regel Keramik, einer Wärmebehandlung unterzogen, bei der durch Sintern metallische Leitbahnen auf dem Substrat erhalten werden können. Für das Sintern werden Temperaturen oberhalb 800 °C erforderlich, so daß nur entsprechende Substratmaterialien eingesetzt werden können. Außerdem wird ein Hinweis in allgemeiner Form gegeben, daß bei einer entsprechenden Auswahl von Druckpasten, die bei niederen Temperaturen sintern, auch gedruckte Schaltungen auf Kunstharz-Leiterplatten mittels des Siebdruckverfahrens hergestellt werden könnten. Dabei liegen die erforderlichen Temperaturen jedoch immer noch oberhalb eines Bereiches, der viele kostengünstige Substratmaterialien für eine entsprechende Verwendung ausschließt.

In DE U1 G 90 07 306.1 ist eine flexible Trägerfolie mit gedruckten Widerständen beschrieben, bei der Widerstände mit lötfähigen Anschlußleitungen auf eine flexible Trägerfolie aufgedruckt werden sollen, wobei eine definierte Einstellung des jeweiligen Widerstandes, durch Aufdrucken einer nicht lötfähigen Paste, auf Teilflächen zu dessen Widerstandsverringerung, vorhanden sein sollen.

Neben anderen, ist beispielsweise in DE 196 39 934 ein Verfahren zur Montage eines Halbleiterchips mittels der sog. Flip-Chip-Technik beschrieben. An einem Halbleiter-Chip sind für den Anschluß entsprechende Anschlußflecken ausgebildet, auf die unter Wärmeeinwirkung veränderliche Anschlußpodeste (Bumps) aufgebracht werden. Die Halbleiterchips werden dann im Nachgang dazu über diese Anschlußflecken und Anschlußpodeste mit den Substratanschlüssen kontaktiert, wobei hierfür ein elektrisch leitender Kleber verwendet wird, der durch eine Wärmebehandlung ausgehärtet wird.

Das eigentliche Substrat wird aber auf herkömmliche Art und Weise hergestellt, zur Verfügung gestellt, wie dies bereits vorab beschrieben worden ist.

In DE 196 42 378 A1 ist eine kontaktlose Chipkarte beschrieben, bei der ein Chipkartensubstrat, durch Gießen eines geeigneten Materials in eine Substratform hergestellt wird und dabei gleichzeitig ein Halbleiter-Chip in dem so hergestellten Chipkartensubstrat plaziert und nach Aushärten des Chipkartensubtratmaterials im Chipkartensubstrat fixiert ist. Im Anschluß daran wird auf die Oberfläche eine leitfähige Paste aufgebracht und mit der leitfähigen Paste eine Spulenstruktur ausgebildet. Diese Vorgehensweise ist zum einen durch die Verwendung solcher Chipkartensubstratmaterialien aufwendig und es sind durch die Auswahl dieser Materialien Grenzen bezüglich der Flexibilität einer solchen Chipkarte und für bestimmte Anwendungsfälle gesetzt.

In EP 0 818 752 A2 ist eine Leiterplatte für Chipkarten beschrieben, bei der in herkömmlicher Form eine metallisierte Leiterplatte Verwendung findet, auf der ein Halbleiter-Chip mittels Flip-Chip-Technik mit Leiterbahnen kontaktiert wird.

Aus DE 44 43 979 C1 ist es bekannt, daß auf Chipkarten zur kontaktlosen Datenübertragung auch Kondensatoren ausgebildet werden können.

In DE 196 32 117 C1 ist ein Datenträger zur kontaktlosen Übertragung von elektrischen Signalen beschrieben, bei dem zwischen zwei Lagen, die aus Pappe oder Papier bestehen sollen, ein Halbleiter-Chip, der zumindest teilweise von einem Versteifungselement umgeben sein soll, angeordnet und gehalten werden soll. Als Versteifungselement kann eine aus Draht gebildete Induktionsspule dienen.

In EP 0 706 152 A2 ist wiederum eine Chipkarte und ein entsprechendes Verfahren zur Herstellung einer solchen Chipkarte beschrieben, bei der wiederum auf die herkömmliche Flip-Chip-Technik zurückgegriffen wird. Diese Chipkarte wird im wesentlichen aus mehreren übereinander angeordneten Folien gebildet, in denen ein Halbleiter-Chip aufgenommen und mit deren Hilfe er innerhalb einer in einer solchen Folie ausgebildeten Aussparung gehalten und beidseitig von Folien umschlossen ist.

Des weiteren ist in EP 0 824 301 A2 eine Chipkarte und ein Verfahren zur Herstellung solcher Karten beschrieben. Dabei wird auf einem Substrat aus einem Kunststoff- oder Keramikmaterial ein Mehrschichtsystem, mit alternierend angeordneten elektrisch leitenden und isolierten Schichten mit einem Siebdruckverfahren aufgebracht, wobei die elektrisch leitenden Schichten untereinander elektrisch leitend verbunden sind und ein Halbleiter-Chip ebenfalls elektrisch leitend verbunden ist.

Eine ähnliche Lösung kann EP 0 855 675 A2 entnommen werden. Bei der dort beschriebenen Lösung wird ein Halbleiter-Chip mit einer auf einem Substrat ausgebildeten Antennenstruktur kontaktiert und das so vorbereitete Substrat beidseitig mit einer laminierten Abdeckung belegt, wobei großen Wert auf die Verringerung der Dicke gelegt wird, so dass verschiedenste Anwendungsmöglichkeiten, wie die Integration in ein Passport, eine Kreditkarte, ein Einlassticket oder eine Briefmarke möglich werden soll, wobei insbesondere im letztgenannten Fall, das entsprechend vorbereitete Gebilde, beidseitig in Papier eingebettet werden soll.

In der FR 2 756 955 A1 ist ein Verfahren zur Herstellung von Chipkarten beschrieben, wobei eine auf einem Substrat ausgebildete Antennenstruktur in der bereits erwähnten Flip-Chip-Technik mit einem Halbleiter-Chip kontaktiert werden soll und im Anschluss daran, der Halbleiter-Chip und die Antennenstruktur mit Laminatschichten abgedeckt werden. Aus der JP 8 202 844 geht ein elektronisches Bauteil hervor, welches als Chipkarte oder Speicherkarte einsetzbar ist. Als Träger kommt Papier oder synthetisches Papier zum Einsatz, welches mit einer Leitpaste und auschließend mit einem anisotropen Klebstoff beschichtet wird. Derartige Bauteile sind für die kontaktlose Datenübertragung nicht geeignet.

Es ist daher Aufgabe der Erfindung, ein Verfahren zur Herstellung eines Trägers für Halbleiter-Chips vorzuschlagen, das einfach und kostengünstig Elemente zur kontaktlosen Datenübertragung zur Verfügung stellt bzw. herstellbar macht.

Erfindungsgemäß wird diese Aufgabe mit den Merkmalen des Patentanspruchs 1 gelöst. Vorteilhafte Ausgestaltungsformen und Weiterbildungen der Erfindung ergeben sich mit den in den untergeordneten Ansprüchen genannten Merkmalen.

Außerdem kann die Erfindung vorteilhaft für Chipkarten, als Transponder, Datenträger oder auch für Identifikationssysteme (z.B. Etiketten) benutzt werden, wie dies für die eingangs bereits genannten Anwendungsfälle bezüglich der Remoute-Coupling-Karten der Fall ist. Ein weiterer bisher nicht genannter Anwendungsfall, bei dem die Erfindung vorteilhaft eingesetzt werden kann, besteht in der Markierung von verschiedenen Sendungen, die auf dem Versandwege kontaktlos identifiziert und entsprechend sortiert weitergeleitet werden können.

Die Erfindung baut auf die aus der Flip-Chip-Technik bekannten Erkenntnisse und Vorteile auf und ermöglicht eine sehr einfache und kostengünstige Herstellung von Trägern, die zur kontaktlosen Datenübertragung geeignet sind. Dabei verringert sich einmal die Anzahl der erforderlichen Herstellungsverfahrensschritte und auch die Anzahl verschiedener Verfahrensführungen. In ganz besonders günstiger Weise entfällt das aufwendige und kostenintensive Naßätzen der Träger. Außerdem eröffnen sich mit der erfindungsgemäßen Lösung Möglichkeiten für den Einsatz neuer bisher nicht verwendbarer Materialien als Träger bzw. Substrat, mit denen eine weitere Kostenreduzierung erreicht werden kann.

Erfindungsgemäß wird daher so vorgegangen, dass bei der Herstellung einer elektronischen Anordnung mit einem flexiblen flächigen Träger aus einem elektrisch isolierenden Material und mit einer Leiterbahnstruktur zur kontaktlosen Datenübertragung die Leiterbahnstruktur durch Aufdrucken eines elektrisch leitenden Polymers oder Klebers ummittelbar auf die Oberfläche des Trägers hergestellt und der Halbleiter-Chip auf die aufgedruckte Leiterbahnstruktur nach dem Flip-Chip-Verfahren aufgesetzt und mit letzterer elektrisch kontaktiert wird, wobei der Träger aus Papier, Karton, Pappe oder einem textilen Material besteht und der Halbleiter-Chip unmittelbar mit der nicht ausgehärteten Leiterbahnstruktur kontaktiert wird. Dabei wird der die Leitbahnstruktur ausbildende elektrisch leitende Kleber oder die Polymerpaste unmittelbar auf die Oberfläche des flexiblen Trägers aufgedruckt und ganz besonders vorteilhaft, mit einem bekannten Siebdruckverfahren aufgedruckt.

Beim Drucken kann ein Teil der Leitbahnstruktur eine Spule mit mindestens einer Windung ausbilden, über die sowohl die kontaktlose Daten- und auch kontaktlose Energieübertragung auf induktivem Wege erfolgen kann. Dabei kann die geometrische Form der Spule und die jeweilige Anzahl der für die Spule zu verwendenden Windungen sowie deren stoffliche Zusammensetzung entsprechend der jeweiligen Applikation ohne weiteres angepaßt werden.

Die noch nicht ausgehärtete Leiterbahnstruktur kann durch aufsetzen eines Halbleiter-Chips mit diesem kontaktiert werden, wobei eine Aushärtung im Nachgang erfolgen kann.

Außerdem besteht mit der erfindungsgemäßen Lösung, auf einfache Art und Weise, die Möglichkeit, Leitbahnstrukturen auf beiden Seiten eines solchen flächigen Trägers auszubilden, wobei in diesem Fall elektrisch leitende Verbindungen über Bohrungen im Trägermaterial, die ebenfalls mit elektrisch leitendem Kleber ausfüllbar sind, hergestellt werden können. Solche Bohrungen können relativ einfach und schnell in sehr kleiner Dimensionierung unter Verwendung von Laserstrahlen in die verschiedensten Trägermaterialien, bevorzugt vor dem Aufdrucken des elektrisch leitenden Klebers eingebracht werden.

Als Halbleiter-Chip können Mikroprozessoren bzw. Speicherschaltkreise, die generell auch als Module ausgebildet sind, verwendet werden. Die kontaktlose Datenübertragung kann aber auch auf kapazitivem Wege mit der erfindungsgemäßen Lösung erreicht werden. Hierfür bildet ein Teil der Leitbahnstruktur einen Kondensator aus. Der Kondensator kann so gebildet werden, daß entsprechende Flächen gegenüber liegend auf beiden Seiten des dielektrischen Trägers aufgedruckt werden, so daß ein Plattenkondensator ausgebildet wird.

Eine weitere Möglichkeit zur Herstellung eines Kondensators besteht darin, daß eine bestimmte Fläche auf einer Seite des Trägers mit dem elektrisch leitenden Kleber bedruckt wird - diese Fläche im Nachgang dazu, mit einer isolierenden Schicht überklebt bzw. überdruckt und im Anschluß daran wieder eine Schicht aus dem elektrisch leitenden Kleber aufgedruckt wird. An den den Kondensator ausbildenden elektrisch leitenden Flächen sind wiederum Verbindungsbahnen, der Leitbahnstruktur zum jeweiligen Halbleiter-Chip vorhanden, die gleichzeitig gedruckt werden, wie die Kondensatorplatten. Als besonders günstig hat es sich herausgestellt, für den Träger Papier, Karton, Pappe oder einen textilen Träger (Gewebe, Gewirk, Fließ ggf. imprägniert) zu verwenden, die kostengünstig beschaff- und bedruckbar sind. Diese Materialien sollten jedoch an der bzw. den Seiten, auf denen die Leitbahnstruktur aufgedruckt werden soll, imprägniert bzw. bestrichen sein, um zumindest dem Eindringen des während des Aufdruckens pastösen elektrische leitenden Klebers entgegen zu wirken, so daß der größte Teil des aufgedruckten elektrisch leitenden Klebers auf der Oberfläche des Trägers verbleibt. Zum Imprägnieren bzw. Streichen können aus der Papierindustrie bekannte Stoffe ohne weiteres verwendet werden.

Günstig kann es sein, die auf dem Träger ausgebildete Leitbahnstruktur mit einem elektrisch isolierenden Überzug zu beschichten, um möglichen Kurzschlüssen entgegen zu wirken.

Eine solche Beschichtung kann z.B. ein zweiter Kleber sein, der in diesem Fall selbstverständlich elektrisch nicht leitend ist und der zusätzlich temporär mit einer Folie oder Papier temporär abgedeckt werden kann. Dadurch besteht die Möglichkeit, eine solche Folie bzw. das Papier bei Bedarf abzuziehen und den mit Leitbahnstruktur und Halbleiter-Chip versehenen Träger, wie ein Etikett an die verschiedensten Gegenstände zu kleben. Die so markierten Gegenstände können dann mit geeigneten induktiven bzw. kapazitiven Sensoren berührungslos identifiziert werden, so daß eine gezielte Sortierung von beispielsweise Gepäck oder Expreßgutsendungen automatisiert erfolgen können. Selbstverständlich besteht auch die Möglichkeit, andere Informationen kontaktlos aus dem Halbleiter-Chip auszulesen bzw. entsprechende Daten zum Halbkreis-Schaltkreiselement zu übertragen und dort zu speichern, wie dies z.B. beim bargeldlosen Zahlungsverkehr oder der Warenlogistik der Fall sein kann.

Mit der erfindungsgemäßen Lösung besteht die Möglichkeit, sowohl die Leitbahnstruktur, wie auch das jeweilige Halbleiter-Chip, unter Verwendung des gleichen elektrisch leitenden Klebers auf den Träger zu bringen und beide miteinander elektrisch leitend zu kontaktieren, so daß der Aufwand für das Herstellungsverfahren weiter verringert werden kann. Die Aushärtung des elektrisch leitenden Klebers wird, bevorzugt zur Verkürzung der Aushärtzeit, durch Energiezufuhr beschleunigt. Hierfür kann z.B. eine Wärmebehandlung in einem Ofen, aber auch eine Beheheizung mit elektrischem Strom oder die Bestrahlung mit Wärme, infrarotem, ultravioletem oder sichtbaren Licht vorgenommen werden, wobei die Temperaturen unterhalb 120 °C, bevorzugt bei maximal 100 °C gehalten werden sollten. Dieser Temperaturbereich sichert, daß keine Schäden am Halbleiter-Chip und keine unerwünschten Veränderungen am Trägermaterial, auch wenn hierfür Papier, Karton oder Pappe verwendet wird, auftreten. Werden Papier, Karton, Pappe oder ein textiler Träger als Trägermaterial verwendet, kann ggf. auch auf den bei der herkömmlichen Flip-Chip-Technik verwendeten, sog. Underfiller verzichtet werden, da diese Materialien infolge unterschiedlicher Wärmeausdehnungen auftretenden Scherspannungen ohne weiteres ausgleichen können.

Mit dem erfindungsgemäßen Aufdruck der Leitbahnstruktur auf den Träger, kann auch eine sehr hohe Miniaturisierung erreicht werden, wobei es ohne weiteres möglich ist, einzelne Bahnen der Leitbahnstruktur mit einer Bahnbreite und einem Abstand zwischen einzelnen Bahnen der Leitbahnstruktur unterhalb 100 µm zu erreichen. Die Höhe der Leitbahnstruktur kann < 40 µm, bevorzugt < 25 µm gehalten werden.

Die Leitbahnstruktur und insbesondere die Koppelelemente können in ihrem Layout und ihrer Dimensionierung sehr einfach und flexibel optimiert werden, so daß beispielsweise eine große Reichweite für die kontaktlose Datenübertragung, eine hohe Übertragungssicherheit und eine sichere Energieversorgung des Halbleiter-Chips erreichbar sind.

Der Träger zeichnet sich durch eine sehr gute Haftung der aufgedruckten Leitbahnstruktur aus, so daß der Träger, ohne Leitbahnbruch auch um relativ kleine Radien, zumindest unterhalb 5 mm Radius gebogen werden kann und auch in diesem Fall, kein Ablösen oder Brechen der Leitbahnstruktur zu verzeichnen ist.

Der Träger kann ohne weiteres in der bereits beschriebenen Form für die kontaktlose Datenübertragung eingesetzt werden. Es besteht aber auch die Möglichkeit, durch Verwendung geeigneter, bereits bekannter Kunststoffe etwas stabilere Chipkarten herzustellen. Dabei kann beispielsweise ein Farbdruck auf die Seite des Trägers aufgedruckt werden, auf der keine Leitbahnstruktur ausgebildet wird, die im Anschluß mittels eines transparenten Kunststoffes abgedeckt wird. Dadurch können die Probleme, die beim Drucken bestimmter Kunststoffarten auftreten, umgangen und der ästhetische Gesamteindruck eines solchen Druckbildes erhalten werden.

Selbstverständlich können auch mehrere Halbleiter-Chips auf einem Träger aufgebracht oder mehrere Träger als Stapel übereinander angeordnet werden, wobei im letzten Fall die Leitbahnstrukturen der verschiedenen Träger in gewünschter Form elektrisch leitend miteinander verbunden werden und ansonsten isoliert sind.

Auf den Träger können zusätzlich auch Informationen in optisch detektierbarer Form aufgebracht sein, die mittels Scannern oder elektronischen Bildverarbeitungssystemen ausgelesen werden. Dabei kann es sich um herkömmliche Strich- oder Barcodes handeln, die sich ohne weiteres auf Papier, Karton, Pappe oder textile Materialien aufdrucken und auf optischem Wege dann die Informationen auslesen lassen.

Es besteht die Möglichkeit, auch zumindest einen Teil der Leiterbahnstruktur in Form eines Strich- oder Barcodes auf das Trägermaterial aufzudrucken, so daß eine Doppelfunktion erfüllbar ist.

Zur Verbesserung der Erkennbarkeit der aufgedruckten Informationen ist es günstig, das Trägermaterial zumindest im Bereich in dem die Informationen aufgedruckt sind, in Bezug zu den aufgedruckten Informationen kontrastreich einzufärben. Dies wirkt sich insbesondere dann vorteilhaft aus, wenn ein Teil der Leiterbahnstruktur als Informationsträger entsprechend ausgenutzt wird, da der verwendete elektrisch leitende Kleber in diesem Fall dann nicht zwingend eingefärbt werden muß, um das Kontrastverhältnis zwischen dem Trägeruntergrund und dem elektrisch leitenden ausgehärteten Kleber ausreichend hoch zu halten, um ein sicheres optisches Auslesen der Informationen zu sichern.

Ein Träger kann gleichzeitig mehrere Funktionen erfüllen, so daß sich verschiedene Anwendungsmöglichkeiten ergeben.

Nachfolgend soll die Erfindung an einem Beispiel näher erläutert werden.

Dabei zeigt:

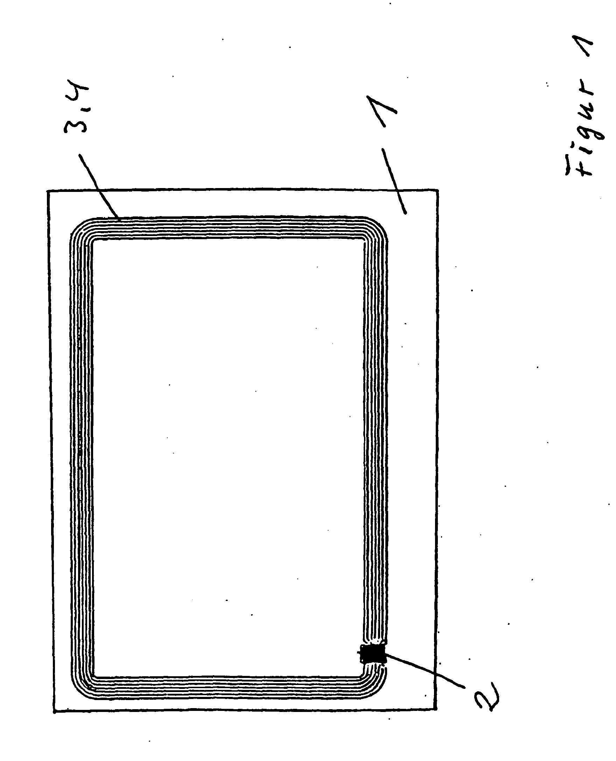

- Figur 1: ein Beispiel eines Trägers mit einer Spule als Leitbahnstruktur, die mit einem Speicherschaltkreis als Halbleiter-Chip auf einem Träger aufgebracht ist.

Die die Leitbahnstruktur 3 darstellende Spule 4 wird im Siebdruck mit bevorzugt isotropem elektrisch leitendem Kleber, der unter der Bezeichnung DP 5029 von der Firma Du Pont oder 408 der Firma Acheson kommerziell erhältlich ist und in dem leitende Partikel mit maximalem Durchmesser von 25 µm enthalten sind, mit einem ensprechend ausgebildeten metallischen Sieb im Siebdruckverfahren auf, bei diesem Beispiel einen Träger 1 aus Papier aufgedruckt. Die die Spule aus Papier ausbildende Leitbahnstruktur 3 besteht bei diesem Beispiel aus insgesamt sieben Windungen, deren Abmaße und Abstände unterhalb der im allgemeinen Teil der Beschreibung genannten Größen liegen.

Die einzelnen Windungen der Spule 4 sind mit dem hier als Speicherschaltkreis 2 verwendeten Halbleiter-Chip mittels bekannter Flip-Chip-Technik elektrisch leitend verbunden, wobei die einzelnen Leitbahnen an den Kontaktstellen ebenfalls im Siebdruck punktuell mit elektrisch leitendem Kleber bedruckbar sind, wobei der Druck dem jeweiligen Anschlußmuster des verwendeten Schaltkreiselementes 2 entspricht. Das Bedrucken der Leitbahnstruktur 3 und dieser Kontaktflecken kann naß in naß oder gleichzeitig erfolgen und im Anschluß an die Bestückung mit dem Halbleiter-Chip die Aushärtung in einem einzigen Verfahrensschritt durchgeführt werden.

Selbstverständlich können gleichzeitig auf einem großformatigen Trägermaterial durch gleichzeitiges Bedrucken mehrere solcher Träger 1 bedruckt und bestückt werden, die im Nachgang, z.B. durch Schneiden vereinzelt werden können.

## Patentansprüche

1. Verfahren zur Herstellung von einer elektronischen Anordnung mit einem flexiblen flachigen Träger aus einem elektrisch Isolierenden Material und mit einer Leiterbahnstruktur zur kontaktlosen Datenübertragung, bei dem die Leiterbahnstruktur (3) durch Aufdrucken eines elektrisch leitenden Polymers oder Klebers unmittelbar auf die Oberfläche des Trägers (1) hergestellt und der Helbleiter-Chip (2) auf die aufgedruckte Leiterbahnstruktur (3) nach dem Flip-Chip-Verfahren aufgesetzt und mit letzterer elektrisch kontaktiert wird, wobei der Träger (1) aus Papier, Karton, Pappe oder einem textilen Material besteht und der Halbleiter-Chip (2) unmittelbar mit der nicht ausgehärteten Leiterbahnstruktur (3) kontaktiert wird.

2. Verfahren nach Anspruch 1, **dadurch gekennzeichnet, dass** die Leiterbahnstruktur (3) im Siebdruck aufgebracht wird.

3. Verfahren nach Anspruch 1 oder 2, **dadurch gekennzeichnet, dass** der elektrisch leitende Kleber für die Kontaktierung des Halbleiter-Chips (2) im Siebdruck, Schablonendruck, Tampondruck oder Pin-Transfer aufgebracht wird.

## Claims

1. Method for producing an electronic arrangement with a flexible planar support composed of an electrically insulating material and with a conductor track structure for contactless data transmission, in which the conductor track structure (3) is produced by printing an electrically conductive polymer or adhesive directly onto the surface of the support (1) and the semiconductor chip (2) is placed onto the printed-on conductor track structure (3) according to the flip-chip method and is electrically contact-connected to said conductor structure, wherein the support (1) is composed of paper, cardboard, paperboard or a textile material, and the semiconductor chip (2) is contact-connected directly to the uncured conductor track structure (3).

2. Method according to Claim 1,
**characterized**
**in that** the conductor track structure (3) is applied by screen printing.

3. Method according to Claim 1 or 2,
**characterized in that** the electrically conductive adhesive for the contact-connection of the semiconductor chip (2) is applied by screen printing, mask printing, pad printing or pin transfer.

## Revendications

1. Procédé pour la fabrication d'un dispositif électronique comprenant :
un support plat flexible à base d'un matériau électroisolant et une structure de piste conductrice pour la transmission de données sans contact,
dans lequel
la structure de piste conductrice (3) est fabriquée par application d'un polymère électroconducteur ou d'une colle électroconductrice directement sur la surface du support (1) et la puce à semi-conducteur (2) est posée sur la structure de piste conductrice (3) appliquée dessus dans la technique de Flip-Chip et est mise en contact électrique avec celle-ci,
dans lequel
le support est à base de papier, de carton ou d'un matériau textile et la puce à semi-conducteur (2) est mise en contact directement avec la structure de piste conductrice (3) non durcie.

2. Procédé selon la revendication 1,
**caractérisé en ce que**
la structure de piste conductrice (3) est appliquée par sérigraphie.

3. Procédé selon l'une quelconque des revendications 1 ou 2,
**caractérisé en ce que**
la colle électroconductrice est appliquée pour l'établissement du contact de la puce à semi-conducteurs (2) par sérigraphie, impression au pochoir, impression au tampon ou "pintransfer".
